# EUROPEAN PATENT APPLICATION

(11) **EP 0 709 200 A1**
(43) Date of publication of application: **01.05.1996**
(21) Application number: 95116823.6
(22) Date of filing: 25.10.1995
(51) Int. Cl.: B41J 2/16

(54) **A printing head for an ink jet printer and a method for producing the same**

(30) Priority: 26.10.1994 JP 262817/94
(71) Applicant: MITA INDUSTRIAL CO. LTD., Osaka-shi Osaka 540 (JP)
(72) Inventor: Satake, Kenichi, c/o Mita Industrial Co., Ltd., Osaka-shi, Osaka-fu (JP); Baba, Koichi, c/o Mita Industrial Co., Ltd., Osaka-shi, Osaka-fu (JP); Tsuji, Kikunosuke, c/o Mita Industrial Co., Ltd., Osaka-shi, Osaka-fu (JP); Watanabe, Takeshi, c/o Mita Industrial Co., Ltd., Osaka-shi, Osaka-fu (JP); Hori, Setsuo, c/o Mita Industrial Co., Ltd., Osaka-shi, Osaka-fu (JP); Ohba, Yoko, Yokohama-shi, Kanagawa-ken (JP)
(74) Representative: Müller-Boré & Partner Patentanwälte

(57) **Abstract**

A printing head (1) for an ink jet printer includes: a pressure chamber (202) for containing ink, the pressure chamber including a diaphragm (3,31,32) made of a flexible material having titan; an ink nozzle (203) communicated with the pressure chamber (202); and a piezoelectric member (4) including a PZT layer chemically bonded to an outside of the diaphragm (3,31,32) of the pressure chamber (202), the piezoelectric member being electrically activated to cause the diaphragm (3,31,32) to bend into the pressure chamber to eject ink from the ink nozzle (203).

## Description

### BACKGROUND OF THE INVENTION

This invention relates to a printing head for an ink jet printer and a method for producing a printing head.

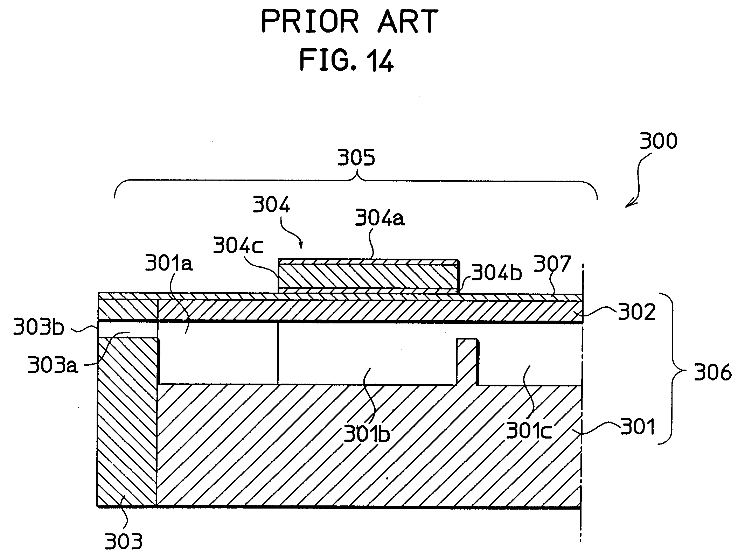

In conventionally known arrangements, a printing head for an ink jet printer employs piezoelectric elements as actuators. FIG. 14 is a fragmentary sectional view showing a construction of a Kyser type printing head. A printing head 300 has on its surface a plurality of dot printing sections 305 arranged in an array extending at right angles to the section of FIG. 14, each dot printing section 305 comprising a front ink passage 301a, a pressure chamber 301b, a rear ink passage 301c, an ink nozzle 303a, an ink jet outlet 303b and a piezoelectric element 304.

The front ink passages 301a, pressure chambers 301b and rear ink passages 301c of the individual dot printing sections 305 are constructed by forming a specific pattern of recesses on a surface of a substrate 301 which is made of photosensitive glass and then bonding a diaphragm 302 to the surface of the substrate 301 with an adhesive. Each piezoelectric element 304 serves as a pressure source for the front ink passage 301a. It is produced by forming electrodes 304a and 304b on opposite surfaces of a piezoelectric member 304c made of lead zirconate-titanate (hereinafter referred to as "PZT"), for instance. The individual piezoelectric elements 304 are bonded to the diaphragm 302 with an adhesive just at the positions of the pressure chambers 301b.

The ink nozzles 303a and ink jet outlets 303b of the individual dot printing sections 305 are made by bonding a nozzle plate 303, in which a pattern of the ink nozzles 303a and ink jet outlets 303b is preformed, to an end of the substrate 301, to which the diaphragm 302 is already attached, by use of an ultraviolet-curing adhesive.

The diaphragm 302 forms flexible walls of the pressure chambers 301b as well as walls of the front ink passages 301a and rear ink passages 301c.

The printing head 300 is produced in the following method. First, a surface of the substrate 301 made of photosensitive glass is subjected to a photolithographic process to form a recessed pattern of the front ink passages 301a, pressure chambers 301b and rear ink passages 301c. Then, the diaphragm 302 also made of photosensitive glass is bonded to the surface of the substrate 301 with the adhesive. The substrate 301 joined with the diaphragm 302 is hereinafter referred to as a head assembly 306.

Next, a layer 307 of indium tin oxide (hereinafter referred to as "ITO") is formed as a common electrode on an outside surface of the diaphragm 302 of the head assembly 306. The piezoelectric elements 304 readily produced as discrete components are bonded to the diaphragm 302 just at the locations of the pressure chambers 301b with an epoxy adhesive. Then, the nozzle plate 303 having a water repellent finish on its ink streaming surfaces is bonded to the front end of the head assembly 306 with the aforementioned ultraviolet-curing adhesive to complete the printing head 300.

This conventional printing head 300 is produced by first constructing the head assembly 306 and then bonding the piezoelectric elements 304 prepared as discrete components to specific locations of the head assembly 306 with the epoxy adhesive. This producing method, including the step of bonding a number of piezoelectric elements 304, somewhat lacks the ease of work and labor efficiency, and it is difficult to align the individual piezoelectric elements 304 with high positioning accuracy.

Especially, when the printing head 300 is made longer for constructing a line head which can print a whole line on standard A4-size paper at a time, for instance, it is extremely important to attach the piezoelectric elements 304 in exact locations on the head assembly 306. This is because the positioning accuracy of the individual piezoelectric elements 304 significantly affects the printing accuracy. The conventional printing head 300, however, is prone to variations in the positioning accuracy and in mounting strength of the piezoelectric elements 304, and the quality of printed images is not stable enough.

### SUMMARY OF THE INVENTION

It is an object of the present invention to provide a printing head for an ink jet printer and a method for producing a printing head which have overcome the above-mentioned problems residing in the prior art.

It is another object of the present invention to provide a printing head for an ink jet printer and a method for producing a printing head which can offer high positioning accuracy and high bonding strength of individual piezoelectric elements as well as stable quality of printed images.

The present invention is directed to a printing head for an ink jet printer comprises: a pressure chamber for containing ink, the pressure chamber including a diaphragm made of a flexible material having titan; an ink nozzle communicated with the pressure chamber; and a piezoelectric member including a PZT layer chemically bonded on an outside of the diaphragm of the pressure chamber, the piezoelectric member being electrically activated to cause the diaphragm to bend into the pressure chamber to eject ink from the ink nozzle.

The diaphragm may be made of a titan plate. The PZT layer may be formed by depositing crystals of PZT on an outside surface of the diaphragm in hydrothermal synthesis.

Also, it may be appreciated that the diaphragm is made of a flexible plate formed with a thin titan layer on the outside thereof; and the PZT layer is chemically bonded on the thin titan layer. The flexible plate may be further formed with a conductive layer under the thin titan layer.

It may be appreciated that the diaphragm is made of a flexible plate formed with an independent electrode made of a thin titan layer and a conductor trace for supplying power to the piezoelectric member; and the PZT layer is chemically bonded on the independent electrode.

The flexible plate may be an alkali-proof glass plate or a synthetic resin plate.

The outside surface of the diaphragm may be formed with a coating layer excluding an area where the piezoelectric member is formed.

The above-constructed printing head will assure an increased bonding strength between the diaphragm and each piezoelectric member, a reduction in variations in bonding strength among separate piezoelectric members, uniform pressurizing force in the pressure chamber due to electrostriction of each piezoelectric member, and thereby stabilizes the ink jet forming performance of the printing head.

The titan plate or thin titan layer serves as one of driving electrodes for the individual piezoelectric members or as a common electrode for a plurality of piezoelectric members, assuring a simplified construction of bonding the piezoelectric members on the diaphragm.

In the case that the outside surface of the diaphragm is formed with a coating layer excluding an area where the piezoelectric member is mounted, also, short circuits between the electrode formed on the outside surface of the diaphragm and the driving electrode formed on the piezoelectric member can properly be prevented, resulting in a reduction in electrical failures of the printing head and defects due to improper producing processes.

In the case that the flexible plate is an alkali-proof glass plate or a synthetic resin plate, vibrations caused by electrostriction of the piezoelectric member are quickly absorbed, resulting in an improvement in formation of ink droplets ejected from the ink jet outlet.

Also, the present invention is directed to a method for producing a printing head comprising the steps of: forming a photoresist layer on the outside surface of a flexible material having titan excluding a specified area; depositing a crystal of PZT in the specified area in hydrothermal synthesis to form a PZT layer; forming an electrode on the PZT layer for electrically driving the PZT layer; and combining the flexible material having the PZT layer to a substrate formed with a recess for a pressure chamber and a recess for an ink nozzle to produce a printing head.

The flexible material may be a titan plate or a flexible plate formed with a thin titan layer on an outside thereof.

The PZT crystal is directly deposited on the diaphragm. Accordingly, a piezoelectric member can be produced on a diaphragm with ease and high positioning accuracy. Especially when a printing head has a plurality of pressure chambers, a plurality of piezoelectric members for the individual pressure chambers can be formed at the same time, resulting in an improvement in production efficiency.

These and other objects, features and advantages of the invention will become more apparent upon a reading of the following detailed description of the preferred embodiments with reference to the appended drawings.

### BRIEF DESCRIPTION OF THE DRAWINGS

FIG. 1 is a fragmentary plan view of a printing head for an ink jet printer as a first embodiment of the invention;
FIG. 2 is a sectional view taken along the line II-II of FIG. 1;
FIG. 3 is a fragmentary sectional view taken along the line III-III of FIG. 1;
FIG. 4 is an enlarged sectional view of a pressurizing section K designated in FIG. 3;
FIGS. 5A-5E are diagrams illustrating a producing method for a printing head according to the invention;
FIG. 6 is a diagram showing how PZT is deposited on a titan plate by hydrothermal synthesis technique;
FIG. 7 is a perspective view showing a line head constructed by a number of printing heads;
FIG. 8 is a fragmentary sectional view of a head block of the line head;
FIG. 9 is a fragmentary sectional view of a printing head as a second embodiment of the invention;
FIG. 10 is a fragmentary sectional view of a printing head as a third embodiment of the invention;
FIG. 11 is a fragmentary plan view of a diaphragm provided with independent electrodes for individual piezoelectric elements as a fourth embodiment of the invention;
FIG. 12 is a fragmentary plan view of a printing head as a fifth embodiment of the invention;
FIG. 13 is a sectional view taken along the line XIII-XIII of FIG. 12; and
FIG. 14 is a fragmentary sectional view showing a conventional Kyser type printing head.

### DETAILED DESCRIPTION OF THE PREFERRED EMBODIMENTS OF THE INVENTION

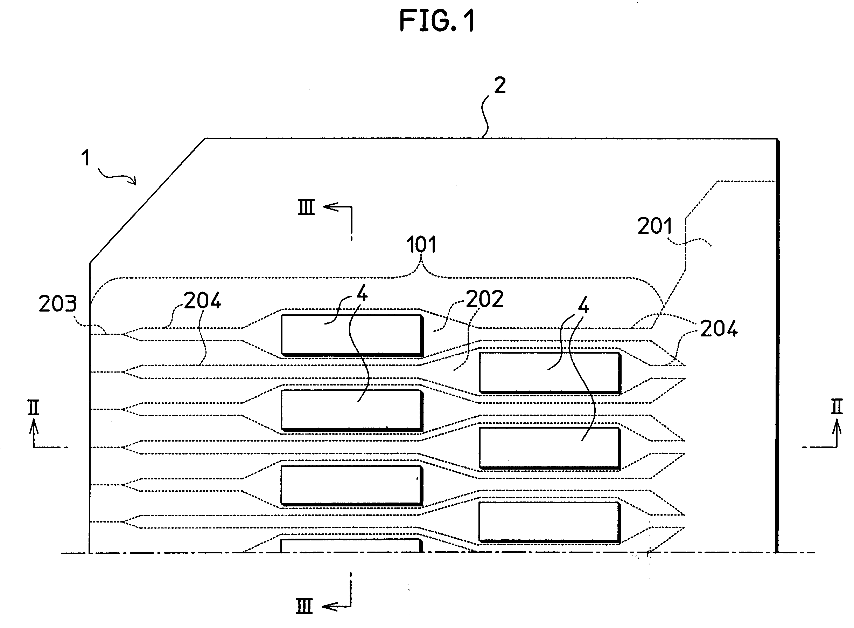

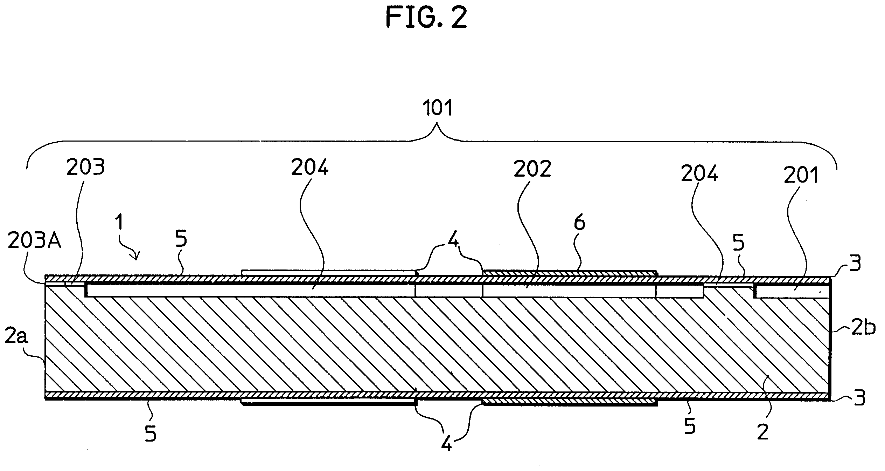

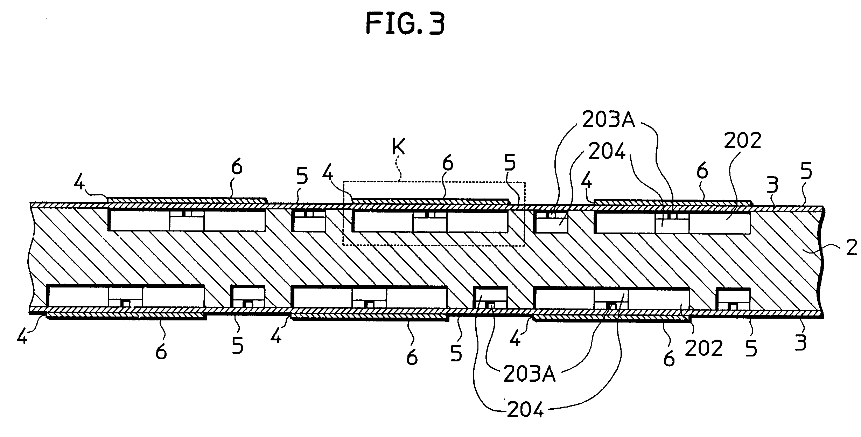

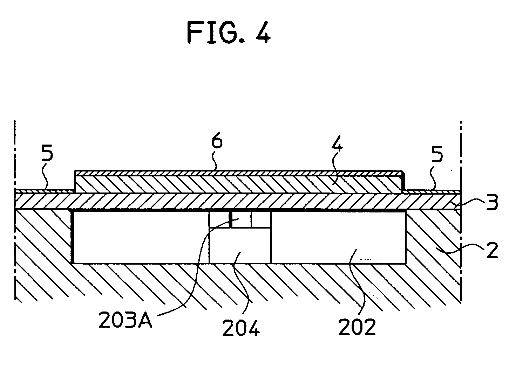

FIG. 1 is a fragmentary plan view of a printing head for an ink jet printer as a first embodiment of the invention; FIG. 2 is a sectional view taken along the line II-II of FIG. 1; FIG. 3 is a fragmentary sectional view taken along the line III-III of FIG. 1; and FIG. 4 is an enlarged sectional view of a pressurizing section K designated in FIG. 3.

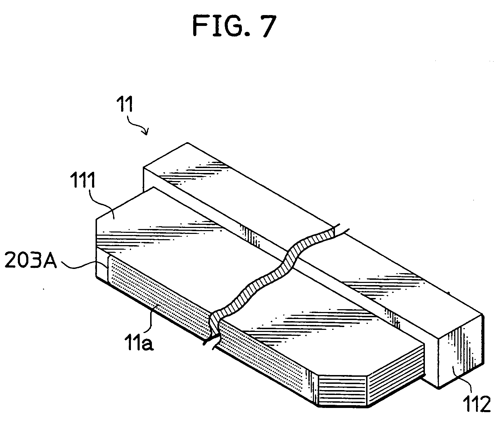

A printing head 1 shown in FIGS. 1-4 is used for a line head 11 of FIG. 7 for printing on standard A4-size paper. In this embodiment, the line head 11 is made by stacking ten printing heads 11 in layers. The construction of the line head 11 will be described later in this specification.

Comprising a substrate 2 made of such insulating material as silicon or photosensitive glass, diaphragms 3 made of titan plates bonded to both sides of the substrate 2 (FIG. 3) and piezoelectric elements 4 made of PZT, the printing head 1 has on its both sides 255 each dot printing sections 101.

The printing head 1 is shaped in a flat-plate form. Measuring the width of the printing head 1 in the direction of array of the dot printing sections 101 and the depth at right angles to the array, the printing head 1 is approximately 220 mm wide by 18 mm deep by 12 mm thick.

Each dot printing section 101 is configured with an ink reservoir 201, a pressure chamber 202, an ink nozzle 203, an ink jet outlet 203A and front and rear ink passages 204 which connect between the ink reservoir 201 and pressure chamber 202 and between the pressure chamber 202 and ink nozzle 203. The individual dot printing sections 101 are made by first forming recessed portions which will serve as the ink reservoirs 201, pressure chambers 202, ink nozzles 203, ink jet outlets 203A and front and rear ink passages 204 on both the top and bottom sides of the substrate 2 and then bonding the diaphragms 3 to both sides with an adhesive. In this configuration, the diaphragms 3 form walls of the ink reservoirs 201, pressure chambers 202, ink nozzles 203, ink jet outlets 203A and front and rear ink passages 204.

As shown in FIG. 2, the ink reservoir 201, rear ink passage 204, pressure chamber 202, front ink passage 204 and ink nozzles 203 of each dot printing section 101 are arranged in a line in this order from the rear end (right side in FIG. 1) to the front end (left side in FIG. 1) of the substrate 2. Each ink jet outlet 203A having a rectangular shape for squirting a stream of ink droplets is provided on a foremost end face 2a of the substrate 2.

The individual dot printing sections 101 are arranged widthwise along the printing head 1 in such a manner that the ink jet outlets 203A align producing a dot pitch of about 0.85 mm. As shown in FIG. 3, the top and bottom arrays of the ink jet outlets 203A are separated by approximately 1 mm from each other, and the individual ink jet outlets 203A in the bottom array are offset by just a half-pitch length with respect to those in the top array.

The ink reservoir 201 from which ink is supplied is shared by all the dot printing sections 101 formed on each side of the printing head 1. The ink reservoir 201 has an opening on a rearmost end face 2b of the printing head 1. Ink is delivered through this opening via a piping from an ink source. The pressure chamber 202 of each dot printing section 101 is for pressurizing ink to produce ink droplets streaming from the relevant ink jet outlet 203A. Pressure is applied to the ink as the wall (i.e., the diaphragm 3) of the pressure chamber 202 is bent inward, causing a reduction in its internal volume, due to the inverse piezoelectric effect of the piezoelectric element 4. To arrange the ink jet outlets 203A at high density, the pressure chambers 202 of the successive dot printing sections 101 are alternately formed in positions mutually offset in their longitudinal direction as shown in FIG. 1.

The ink nozzle 203 of each dot printing section 101 regulates the size of individual ink droplets ejected from the ink jet outlet 203A. The pressure chamber 202, front and rear ink passages 204 and ink nozzle 203 individually have rectangular cross sections and the sectional area is decreased in a step-by-step manner between the pressure chamber 202 and ink jet outlet 203A. In this embodiment, sectional area S1 of the pressure chamber 202, S2 of the ink passages 204 and S3 of the ink nozzle 203 are, for instance, S1 = 0.15 mm², S2 = 0.03 mm² and S3 = 0.0025 mm², respectively. As seen from FIG. 1, transitional portions between the pressure chamber 202 and front and rear ink passages 204 and between the front ink passage 204 and ink nozzle 203 are tapered to prevent sudden changes in the sectional area so that a smooth ink flow is obtained.

On each side of the substrate 2, there is formed a specified pattern of recesses having the shapes of the ink reservoir 201, pressure chambers 202, ink nozzles 203 and front and rear ink passages 204 of the individual dot printing sections 101 by use of photolithographic technique.

As previously mentioned, the diaphragms 3 are bonded to both the top and bottom sides of the substrate 2 to form walls of the ink reservoir 201, pressure chambers 202 and so on of the individual dot printing sections 101. Each diaphragm 3 also serves as a common electrode for the individual piezoelectric elements 4.

The piezoelectric elements 4 are rectangular PZT strips, each measuring approximately 1 mm wide by 4 mm long by 0.02 mm thick. Chemically bonded to the outside surface of each diaphragm 3 at the locations of the pressure chambers 202, they serve as pressure sources of the individual dot printing sections 101.

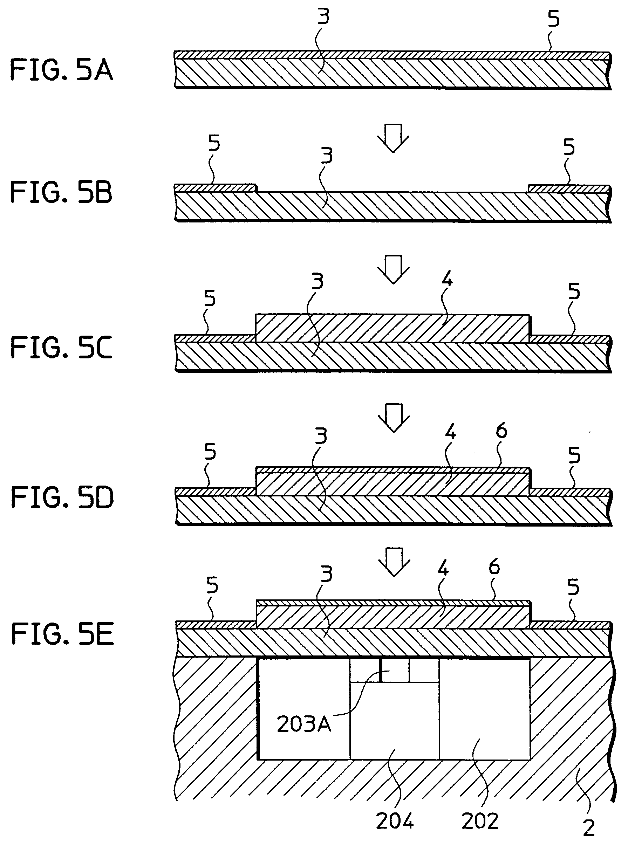

FIGS. 5A-5E are diagrams illustrating a method for producing the printing head 1.

Assuming that the substrate 2 has already been prepared using the aforementioned photolithographic technique, the piezoelectric elements 4 are now formed on each diaphragm (titan plate) 3 by the following the procedure.

First, photoresist 5 is applied to a surface of the titan plate 3 (FIG. 5A). The photoresist 5 is then removed through a photo-etching process from those portions where the piezoelectric elements 4 are to be formed (FIG. 5B). Next, the piezoelectric elements 4 are formed by depositing PZT on the portions from where the photoresist 5 was removed by the hydrothermal synthesis technique (FIG. 5C).

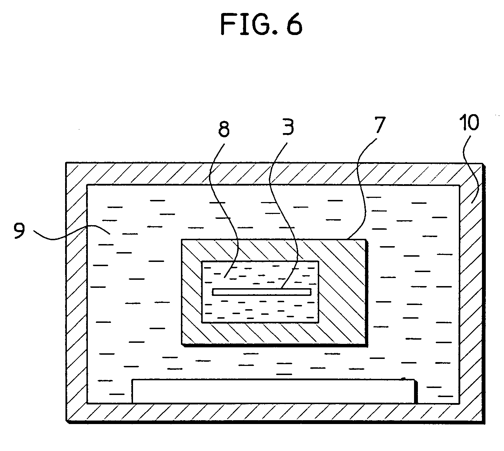

FIG. 6 is a diagram showing how PZT is deposited on the titan plate 3 by the hydrothermal synthesis technique. Deposition of PZT on the titan plate 3 comprises a first step in which crystal nuclei of PZT are formed at specified locations on the titan plate 3 and a second step in which crystals of PZT are grown around the individual crystal nuclei. The second step is repeated until a desired thickness of PZT is obtained.

In the first step, the titan plate 3 is immersed in an autoclave 7 holding an aqueous solution 8 containing lead nitrate (Pb(NO₃)₂), zirconium oxychloride (ZrOCl₂·8H₂O) and potassium hydroxide (KOH(8N)) at a specified ratio so that the molar ratio Pb/Zr between lead (Pb) and zirconium (Zr) becomes approximately 2.29, and the autoclave 7 is placed within a bath of a thermostatic chamber 10 filled with silicone oil 9 and heated under specified temperature conditions (e.g., 150°C for a duration of 48 hours).

In the second step, the titan plate 3 which has undergone the first step is immersed in the autoclave 7 holding another aqueous solution 8' containing lead nitrate (Pb(NO₃)₂), zirconium oxychloride (ZrOCl₂·8H₂O), titanium tetrachloride (TiCl₄) and potassium hydroxide (KOH(4N)) at a specified ratio so that the molar ratio among lead (Pb). zirconium (Zr) and titanium (Ti) becomes Pb:Zr:Ti = 110:52:48, and the autoclave 7 is placed within the bath of the thermostatic chamber 10 filled with silicone oil 9 and heated under specified temperature conditions (e.g., 120°C for a duration of 24 hours).

After the crystals of PZT have been formed at the specified locations on the titan plate 3 using the above-described photolithographic technique, the titan plate 3 is washed with distilled water to complete the step of PZT crystal formation (FIG. 5C).

Subsequently, a nickel (Ni) electrode 6 is formed on the top of each PZT crystal produced on the titan plate 3 to complete the step of forming the piezoelectric elements 4 (FIG. 5D). Now, a pair of diaphragms 3 on which piezoelectric elements 4 have been formed by the foregoing procedure are bonded to appropriate locations on both the top and bottom surfaces of the substrate 2 to complete production of the printing head 1 (FIG. 5E).

As seen above, the piezoelectric elements 4 are formed essentially by crystallizing PZT at the specified locations on the diaphragms 3 through the photolithographic process. This process is effective in increasing the positioning accuracy of the piezoelectric elements 4 on the diaphragms 3. In addition, chemical bonding of the piezoelectric elements 4 to the diaphragms 3 provides great bonding strength and reduces variations in bonding strength between individual piezoelectric elements 4. This helps improve the actuating efficiency and stability of the pressure sources of the individual dot printing sections 101.

In this embodiment, each diaphragm 3 forms part of walls of the individual pressure chambers 202 and serves as a common electrode for the individual piezoelectric elements 4. This arrangement helps simplify the mechanical construction and assembling of the printing head 1 and thus improve labor efficiency.

According to the above-described producing method, the surface of each diaphragm 3 is covered with a coating of the photoresist 5 excluding areas where the piezoelectric elements 4 are formed. With this, short circuits between the nickel electrodes 6 formed on the individual piezoelectric elements 4 and the diaphragm 3 constituting the common electrode can properly be prevented.

FIG. 7 is a perspective view of the line head 11 comprising an assembled stack of multiple printing heads 1.

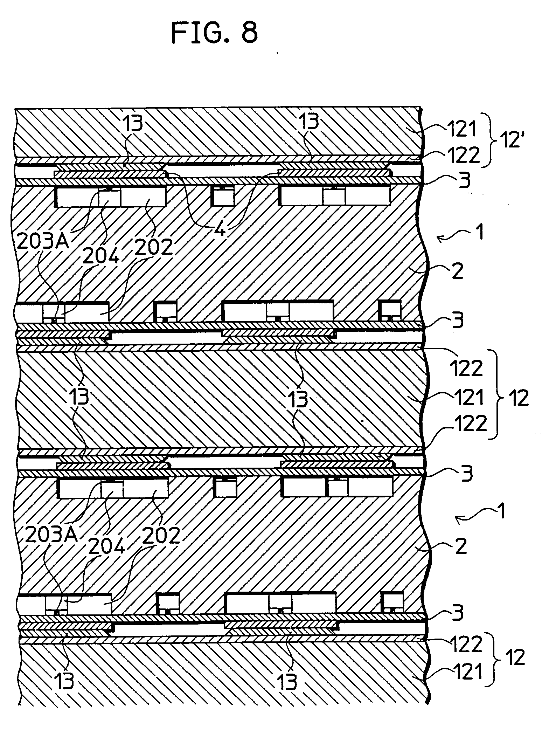

To construct the line head 11, a head block 111 is produced by stacking ten printing heads 1 in electrode plates 12 and 12' in layers as shown in FIG. 8, and the rear end of the head block 111 is supported by a retaining block 112. Consequently, 100 ink jet outlets 203A are arranged in a matrix of 20 rows by 255 columns on a front end face 11a of the line head 11.

It is to be noted that the ink jet outlets 203A in even number rows (i.e., the ink jet outlets 203A formed on the bottom side of each printing head 1) are offset in a lateral direction by as much as half the horizontal dot pitch with respect to the ink jet outlets 203A in odd number rows (i.e., the ink jet outlets 203A formed on the top side of each printing head 1). Also, each printing head 1 is offset widthwise by a length corresponding to the printing resolution (i.e., 0.04255m) of the line head 11 with respect to the printing head 1 one layer below.

The retaining block 112 serves not only as a connector for connecting piezoelectric element control lines provided on the electrode plates 12 and 12' to an unillustrated drive and control circuit, but also as an ink supply unit for supplying ink from an unillustrated ink tank to the ink reservoirs 201 of the individual printing heads 1.

FIG. 8 is a fragmentary sectional view of the head block 111.

As already mentioned, the head block 111 is constructed by stacking ten printing heads 1 together with the electrode plates 12 and 12' in layers. Each electrode plate 12 inserted between two printing heads 1 is made by bonding a pair of flexible printed circuits (hereinafter referred to as "FPC") 122 on which control lines and connecting electrodes 13 are preformed to both sides of an insulator substrate 121. Each electrode plate 12' mounted on the top of the uppermost printing head 1 or on the bottom of the lowermost printing head 1 is produced by bonding one FPC 122 on which control lines and connecting electrodes 13 are preformed to one side of an insulator substrate 121.

The substrate 121 of each electrode plate 12 has a thickness of about 1 mm so that the spacing between the arrays of ink jet outlets 203A becomes about 1 mm.

Having the same shape as the printing heads 1 in plan view, the electrode plates 12 and 12' are pressure-welded to the top and/or bottom of the individual printing heads 1. With this arrangement, the connecting electrodes 13 formed on the FPCs 122 of the electrode plates 12 and 12' are securely connected to the corresponding electrodes 6 formed on the piezoelectric elements 4. As a result, the piezoelectric elements 4 are connected to the respective control lines via the connecting electrodes 13. The individual piezoelectric elements 4 are thus connected to the aforementioned drive and control circuit by way of the control lines of the FPCs 122, diaphragms 3 (common electrodes) and retaining block 112.

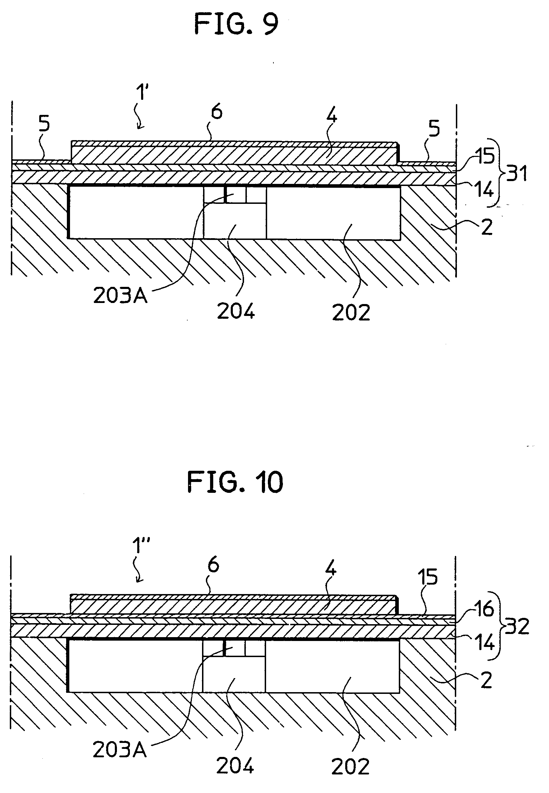

FIG. 9 is a fragmentary sectional view of a printing head 1' as a second embodiment of the invention, corresponding to FIG. 4 of the first embodiment.

The printing head 1' of the second embodiment employs, instead of the diaphragms 3 made of titan plates, diaphragms 31 each comprising a plate 14 made of alkali-proof glass and a thin layer 15 of titan formed on a surface of the plate 14 through a spattering or metallizing process. The printing head 1' is produced by making the piezoelectric elements 4 of PZT at specific locations on the thin layers 15 of titan formed on the diaphragms 31 and then bonding the diaphragms 31 to the top and bottom surfaces of the substrate 2 in the same manner as the first embodiment.

FIG. 10 is a fragmentary sectional view of a printing head 1'' as a third embodiment of the invention, corresponding to FIG. 4 of the first embodiment.

The third embodiment employs a modified form of the diaphragm 31 of the second embodiment. Specifically, the diaphragm 31 of the second embodiment is produced by forming the thin titan layer 15, which will serve as a common electrode for the individual piezoelectric elements (PZT) 4, on a whole surface of the glass plate 14. In the third embodiment, each diaphragm 32 of the printing head 1'' is made by first forming a thin ITO layer 16, which will serve as a common electrode for the individual piezoeleetric elements (PZT) 4, on a whole surface of the glass plate 14 and then forming thin titan layers 15 on the thin ITO layer 16 at specific locations where the piezoelectric elements 4 are to be made.

The printing head 1'' of the third embodiment is also produced by crystallizing PZT on the thin titan layers 15 formed on the diaphragms 32 and then bonding the diaphragms 32 to the top and bottom surfaces of the substrate 2 in the same manner as the first embodiment.

Like the first embodiment, the second and third embodiments provide improved positioning accuracy of the piezoelectric elements 4. Since the second and third embodiments also provide increased bonding strength between the piezoelectric elements 4 and diaphragms 31 (or 32) and reduced variations in bonding strength between the individual piezoelectric elements 4, it is possible to improve the actuating efficiency and stability of the pressure sources of the individual dot printing sections 101.

Furthermore, since the diaphragms 31 and 32 are mainly constructed with glass plates 14, residual oscillation following activation of the piezoelectric elements 4 is quickly attenuated, resulting in an improvement in formation of ink droplets ejected from the individual ink jet outlets 203A. The glass diaphragms 31 and 32 of the second and third embodiments also provide improved machinability compared to titan plates as well as higher bond performance and ink-resistant properties.

Resin plates made of polysulfone or polyether sulfone, for instance, may be substituted for the glass plates 14. Use of resin plates will help reduce production costs since such materials are less expensive compared to titan plates or sheet glass.

Although each diaphragm 3, 31 or 32 to be bonded to the substrate 2 carries a common electrode for the piezoelectric elements 4 in the above embodiments, there may be made independent electrodes for the individual piezoelectric elements 4 on each diaphragm 3, 31 or 32. In this alternative configuration, the independent electrodes are obtainable in the form of separate thin titan layers 15 made through a spattering process, for instance. Since thus made thin titan layers 15 determine the locations where PZT is to be deposited, it is possible to form the piezoelectric elements 4 with ease and high positioning accuracy. In this configuration, the electrodes 6 formed on the outside surfaces of the individual piezoelectric elements 4 serve as earth electrodes and the connecting electrodes 13 formed on each FPC 122 of the electrode plates 12 and 12' are used as common electrodes. The electrodes 6 on the piezoelectric elements 4 are therefore interconnected to each other via the connecting electrodes 13. When the independent electrodes D1 for the piezoelectric elements 4 are formed on each diaphragm 3, 31 or 32, it is possible to pressure-weld the electrode plates 12 and 12' to the printing heads 1 without worrying about positioning accuracy, which makes it easier to assemble the line head 11.

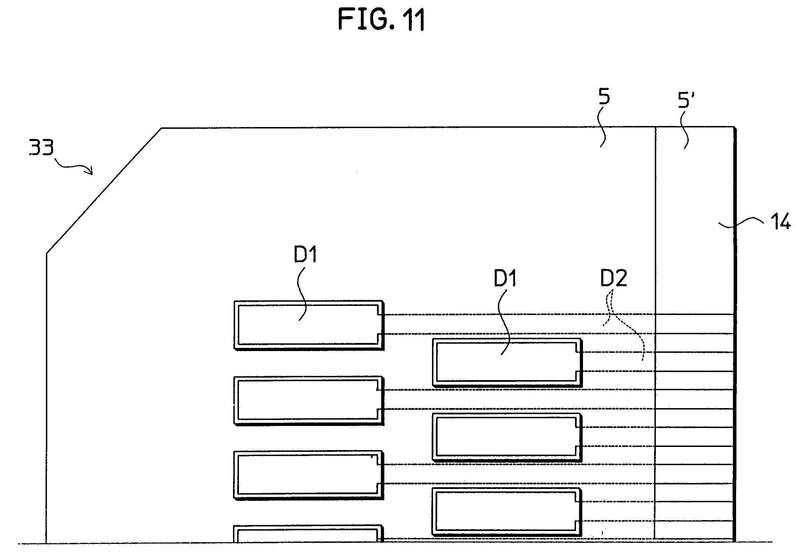

FIG. 11 is a fragmentary plan view of a diaphragm 33 of a printing head as a fourth embodiment of the invention, where independent electrodes for individual piezoelectric elements are provided with the diaphragm 33.

The diaphragm 33 shown in FIG. 11 has essentially the same mechanical construction as the diaphragm 31 of the second embodiment. Specifically, electrodes D1 made of thin titan layers 15 are formed on the top or bottom surface of a glass plate 14 at locations where the piezoelectric elements 4 are to be made and line electrodes D2 are formed to connect between the electrodes D1 and the rear end of the glass plate 14 through a spattering or metallizing process, for instance.

The printing head of the fourth embodiment is produced in accordance with the following procedure. First, a coating of photoresist 5 is produced on the top or bottom surface of each glass plate 14 excluding the locations of the electrodes D1. PZT is deposited on the individual electrodes D1 by the hydrothermal synthesis technique to form the piezoelectric elements 4 and nickel electrodes 6 are made on top of the piezoelectric elements 4. Subsequently, the photoresist 5' along the rear edge of the glass plate 14 is removed to expose the rear portions of the line electrodes D2, and thus produced diaphragms 33 are bonded to a substrate 2.

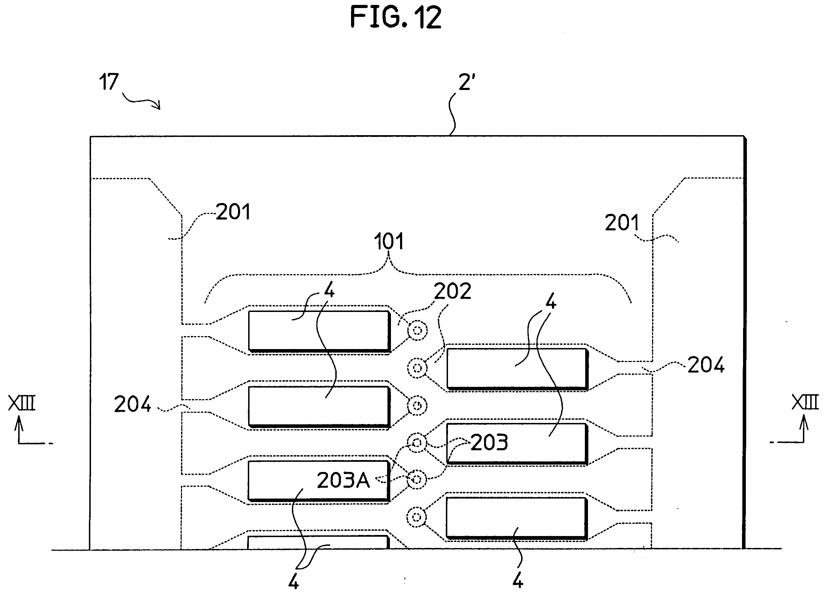

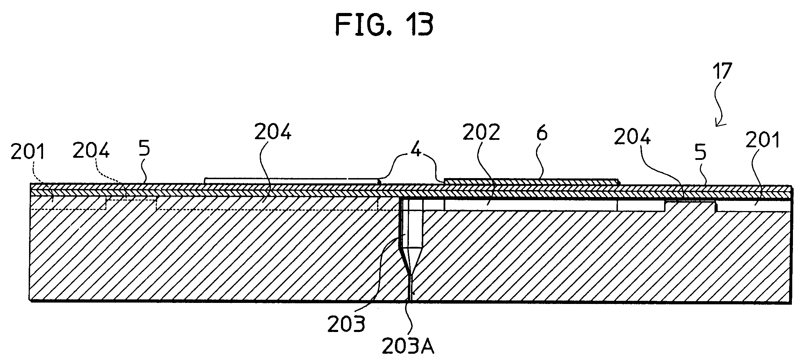

FIG. 12 is a fragmentary plan view of a printing head 17 as a fifth embodiment of the invention; and FIG. 13 is a sectional view taken along the line XIII-XIII of FIG. 12.

In the printing heads 1, 1' and 1'' of the first to fourth embodiments, each dot printing section 101 has the front and rear ink passages 204 and ink nozzle 203 extending horizontally from the pressure chamber 202 and the ink jet outlet 203A is provided on the common longitudinal axis of the front and rear ink passages 204 and ink nozzle 203. The printing head 17 of the fifth embodiment is characterized in that individual ink nozzles 203 extend to the reverse side, downstream of their respective pressure chambers 202, and thus the ink jet outlets 203A are provided on the reverse side of the printing head 17.

In the printing head 17 shown in FIGS. 12 and 13, multiple dot printing sections 101 are arranged on the front side of a substrate 2' in such a manner that a plurality of ink jet outlets 203A are aligned at specified intervals (e.g,, 0.85 mm) on a lateral centerline of the substrate 2'. To achieve high-density arrangement of the ink jet outlets 203A, the dot printing sections 101 designated by even ordinal numbers and those designated by odd ordinal numbers are located essentially symmetrically with respect to the lateral centerline. The fifth embodiment may also be modified to employ the aforementioned diaphragms 31, 32 or 33 instead of the diaphragms 3.

## Claims

1. A printing head (1) for an ink jet printer comprising:
a pressure chamber (202) for containing ink, the pressure chamber (202) including a diaphragm (3; 31; 32) made of a flexible material having titan;
an ink nozzle (203) communicated with the pressure chamber (202); and
a piezoelectric member (4) including a PZT layer chemically bonded on an outside of the diaphragm (3; 31; 32) of the pressure chamber (202), the piezoelectric member (4) being electrically activated to cause the diaphragm (3; 31; 32) to bend into the pressure chamber (202) to eject ink from the ink nozzle (203).

2. A printing head (1) according to claim 1, wherein the diaphragm (3; 31; 32) is made of a titan plate.

3. A printing head (1) according to claim 2, wherein the PZT layer is formed by depositing crystals of PZT on an outside surface of the diaphragm (3; 31; 32) in hydrothermal synthesis.

4. A printing head according to claim 2, wherein the outside surface of the diaphragm (3; 31; 32) is formed with a coating layer excluding an area where the piezoelectric member (4) is formed.

5. A printing head (1) according to claim 1, wherein:
the diaphragm (3; 31; 32) is made of a flexible plate (14) formed with a thin titan layer (15) on the outside thereof; and
the PZT layer is chemically bonded on the thin titan layer (15).

6. A printing head (1) according to claim 5, wherein the flexible plate (14) is further formed with a conductive layer (16) under the thin titan layer (15).

7. A printing head (1) according to claim 5, wherein the flexible plate (14) is an alkali-proof glass plate.

8. A printing head (1) according to claim 5, wherein the flexible plate (14) is a synthetic resin plate.

9. A printing head (1) according to claim 5, wherein the outside surface of the diaphragm (3; 31; 32) is formed with a coating layer excluding an area where the piezoelectric member (4) is formed.

10. A printing head (1) according to claim 1, wherein:
the diaphragm (3; 31; 32) is made of a flexible plate (14) formed with an independent electrode (6) made of a thin titan layer and a conductor trace for supplying power to the piezoelectric member (4); and
the PZT layer is chemically bonded on the independent electrode.

11. A printing head (1) according to claim 10, wherein the flexible plate (14) is an alkali-proof glass plate.

12. A printing head (1) according to claim 10, wherein the flexible plate (14) is a synthetic resin plate.

13. A printing head (1) according to claim 10, wherein the outside surface of the diaphragm (3; 31; 32) is formed with a coating layer excluding an area where the piezoelectric member (4) is formed.

14. A method for producing a printing head (1) comprising the steps of:
forming a photoresistant layer on the outside surface of a flexible material (3; 31; 32) having titan excluding a specified area; depositing a crystal of PZT in the specified area in hydrothermal synthesis to form a PZT layer;
forming an electrode (6) on the PZT layer for electrically driving the PZT layer; and
combining the flexible material (3; 31; 32) having the PZT layer to a substrate formed with a recess for a pressure chamber (202) and a recess for an ink nozzle (203) to produce a printing head.

15. A method for producing a printing head (1) according to claim 14, wherein the flexible material (3; 31; 32) is a titan plate.

16. A method for producing a printing head (1) according to claim 14, wherein the flexible material (3; 31; 32) is a flexible plate (14) formed with a thin layer (15) on an outside thereof.
